(19) **Europäisches Patentamt European Patent Office Office européen des brevets**

(11) **EP 2 379 463 B1**

(12) **FASCICULE DE BREVET EUROPEEN**

(45) Date de publication et mention de la délivrance du brevet:
**21.02.2018 Bulletin 2018/08**

(51) Int Cl.:
***C03C 17/36*** *(2006.01)* ***E06B 3/67*** *(2006.01)*

(21) Numéro de dépôt: **09805779.7**

(86) Numéro de dépôt international:
**PCT/FR2009/052663**

(22) Date de dépôt: **22.12.2009**

(87) Numéro de publication internationale:
**WO 2010/072973 (01.07.2010 Gazette 2010/26)**

(54) **SUBSTRAT MUNI D'UN EMPILEMENT A PROPRIETES THERMIQUES ET A COUCHE ABSORBANTE.**

MIT EINEM MEHRSCHICHTIGEN STAPEL MIT THERMISCHEN EIGENSCHAFTEN UND EINER ABSORBIERENDEN SCHICHT VERSEHENES SUBSTRAT

SUBSTRATE PROVIDED WITH A MULTILAYER STACK HAVING THERMAL PROPERTIES AND AN ABSORBENT LAYER

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **22.12.2008 FR 0858942**

(43) Date de publication de la demande:
**26.10.2011 Bulletin 2011/43**

(73) Titulaire: **Saint-Gobain Glass France 92400 Courbevoie (FR)**

(72) Inventeurs:
• **REYMOND, Vincent**
  **F-92160 Antony (FR)**
• **GERARDIN, Hadia**
  **F-75018 Paris (FR)**
• **BELLIOT, Sylvain**
  **F-75012 Paris (FR)**
• **RONDEAU, Véronique**
  **F-92600 Asnieres Sur Seine (FR)**
• **PETITJEAN, Eric**
  **F-93260 Les Lilas (FR)**

(74) Mandataire: **Saint-Gobain Recherche Département Propriété Industrielle 39 Quai Lucien Lefranc 93300 Aubervilliers (FR)**

(56) Documents cités:
**WO-A-02/48065      WO-A-03/093187
WO-A-2007/080428    FR-A- 2 751 666
US-A- 4 450 201**

**Description**

L'invention concerne un vitrage multiple comportant au moins deux substrats, du type substrats verriers, qui sont maintenus ensemble par une structure de châssis, ledit vitrage réalisant une séparation entre un espace extérieur et un espace intérieur, dans lequel au moins une lame de gaz intercalaire est disposée entre les deux substrats.

D'une manière connue, un des substrat peut être revêtu sur une face intérieure en contact avec la lame de gaz intercalaire d'un empilement de couches minces à propriétés de réflexion dans l'infrarouge et/ou dans le rayonnement solaire comportant une seule couche fonctionnelle métallique, en particulier à base d'argent ou d'alliage métallique contenant de l'argent et deux revêtements diélectriques, lesdits revêtements comportant chacun au moins une couche diélectrique, ladite couche fonctionnelle étant disposée entre les deux revêtements diélectriques.

L'invention concerne plus particulièrement l'utilisation de tels substrats pour fabriquer des vitrages d'isolation thermique et/ou de protection solaire. Ces vitrages peuvent être destinés à équiper les bâtiments, en vue notamment de diminuer l'effort de climatisation et/ou d'empêcher une surchauffe excessive (vitrages dits « de contrôle solaire ») et/ou diminuer la quantité d'énergie dissipée vers l'extérieur (vitrages dits « bas émissifs ») entraînée par l'importance toujours croissante des surfaces vitrées dans les bâtiments.

Ces vitrages peuvent par ailleurs être intégrés dans des vitrages présentant des fonctionnalités particulières, comme par exemple des vitrages chauffants ou des vitrages électrochromes.

Un type d'empilement de couches connu pour conférer aux substrats de telles propriétés est constitué d'une couche métallique fonctionnelle à propriétés de réflexion dans l'infrarouge et/ou dans le rayonnement solaire, notamment une couche fonctionnelle métallique à base d'argent ou d'alliage métallique contenant de l'argent.

Dans ce type d'empilement, la couche fonctionnelle se trouve ainsi disposée entre deux revêtements diélectriques comportant chacun en général plusieurs couches qui sont chacune en un matériau diélectrique du type nitrure et notamment nitrure de silicium ou d'aluminium ou oxyde. Du point de vu optique, le but de ces revêtements qui encadrent la couche fonctionnelle métallique est « d'antirefléter » cette couche fonctionnelle métallique.

Un revêtement de blocage est toutefois intercalé parfois entre un ou chaque revêtement diélectrique et la couche métallique fonctionnelle, le revêtement de blocage disposé sous la couche fonctionnelle en direction du substrat la protège lors d'un éventuel traitement thermique à haute température, du type bombage et/ou trempe et le revêtement de blocage disposé sur la couche fonctionnelle à l'opposé du substrat protège cette couche d'une éventuelle dégradation lors du dépôt du revêtement diélectrique supérieur et lors d'un éventuel traitement thermique à haute température, du type bombage et/ou trempe.

Pour rappel, le facteur solaire d'un vitrage est le rapport de l'énergie solaire totale entrant dans le local à travers ce vitrage sur l'énergie solaire incidente totale et la sélectivité correspond au rapport de la transmission lumineuse $T_{Lvis}$ dans le visible du vitrage sur le facteur solaire FS du vitrage et est telle que : $S = T_{Lvis}$ / FS.

Actuellement, il existe des empilements de couches minces bas-émissifs à une seule couche fonctionnelle (désignés par la suite sous l'expression « empilement monocouche fonctionnelle »), à base d'argent, présentant une émissivité normale $\varepsilon_N$ de l'ordre de 2 à 3 %, une transmission lumineuse dans le visible $T_L$ de l'ordre de 65 % et une sélectivité de l'ordre de 1,3 à 1,35 pour un facteur solaire d'environ 50 % lorsqu'ils sont montés dans un double vitrage classique, comme par exemple en face 3 d'une configuration : 4-16(Ar-90%)-4, constituée de deux feuilles de verre de 4 mm séparée par une lame de gaz intercalaire à 90 % d'argon et 10 % d'air d'une épaisseur de 16 mm, dont l'une des feuilles est revêtue de l'empilement monocouche fonctionnelle : la feuille la plus à l'intérieur du bâtiment lorsque l'on considère le sens incident de la lumière solaire entrant dans le bâtiment ; sur sa face tournée vers la lame de gaz intercalaire.

L'homme du métier sait que positionner l'empilement de couches minces en face 2 du double vitrage (sur la feuille la plus à l'extérieur du bâtiment lorsque l'on considère le sens incident de la lumière solaire entrant dans le bâtiment et sur sa face tournée vers la lame de gaz) lui permettra de diminuer le facteur solaire et d'augmenter ainsi la sélectivité.

Dans le cadre de l'exemple ci-dessus, il est alors possible d'obtenir une sélectivité de l'ordre de 1,5 avec le même empilement monocouche fonctionnelle.

Toutefois cette solution n'est pas satisfaisante pour certaines applications car la réflexion lumineuse dans le visible, et en particulier la réflexion lumineuse dans le visible vue de l'extérieur du bâtiment est à un niveau relativement élevé, supérieur à 20 %, et d'environ 23 à 25 %.

Pour diminuer cette réflexion lumineuse, tout en conservant la réflexion énergétique, voire même en l'augmentant, l'homme du métier sait qu'il peut introduire dans l'empilement, et plus particulièrement à l'intérieur d'un (ou de plusieurs) revêtement(s) diélectrique(s), une (ou plusieurs) couche(s) absorbante(s) dans le visible.

Il est apparu que certaines règles devaient être respectées pour le positionnement d'un empilement monocouche fonctionnelle dans un vitrage multiple, en fonction du positionnement de la (ou des) couche(s) absorbante(s) dans le visible : c'est l'objet de la présente invention.

Il est à noter que l'art antérieur connaît déjà l'usage de telles couches absorbantes dans le visible dans des empilements à plusieurs couches fonctionnelles, en particulier de la demande internationale de brevet N° WO 02/48065 qui porte sur l'usage de telles couches absorbantes dans le visible dans un empilement résistant à un traitement thermique du type bombage/trempe.

Toutefois, du fait de la complexité de l'empilement et de la quantité de matière déposée, ces empilements à plusieurs couches fonctionnelles coûtent plus cher à fabriquer que des empilements monocouche fonctionnelle.

Par ailleurs, du fait également de la complexité de cet empilement bicouches fonctionnelles, l'enseignement de ce document n'est pas directement transposable pour la conception d'un empilement monocouche fonctionnelle.

Le but de l'invention est de parvenir à remédier aux inconvénients de l'art antérieur, en mettant au point un nouveau type d'empilement de couches monocouche fonctionnelle, empilement qui présente une faible résistance par carré (et donc une faible émissivité), une transmission lumineuse élevée et une couleur relativement neutre, en particulier en réflexion côté couches (mai aussi côté opposé : « côté substrat »), et que ces propriétés soient de préférence conservées dans une plage restreinte que l'empilement subisse ou non, un (ou des) traitement(s) thermique(s) à haute température du type bombage et/ou trempe et/ou recuit.

Un autre but important est de proposer un empilement monocouche fonctionnelle qui présente une émissivité faible tout en présentant une faible réflexion lumineuse dans le visible, ainsi qu'une coloration acceptable, notamment en réflexion extérieure du vitrage multiple, en particulier qui ne soit pas dans le rouge.

L'invention a ainsi pour objet, dans son acception la plus large, un vitrage multiple selon la revendication 1 ou la revendication 2. Ce vitrage multiple comporte respectivement au moins deux substrats ou au moins trois substrats qui sont maintenus ensemble par une structure de châssis, ledit vitrage réalisant une séparation entre un espace extérieur et un espace intérieur, dans lequel au moins une lame de gaz intercalaire est disposée entre les deux substrats, un substrat étant revêtu sur une face intérieure en contact avec la lame de gaz intercalaire d'un empilement de couches minces à propriétés de réflexion dans l'infrarouge et/ou dans le rayonnement solaire comportant une seule couche fonctionnelle métallique, en particulier à base d'argent ou d'alliage métallique contenant de l'argent et deux revêtements diélectriques, lesdits revêtements comportant chacun au moins deux couches diélectriques, ladite couche fonctionnelle étant disposée entre les deux revêtements diélectriques. Selon l'invention les deux revêtements diélectriques comportent une couche absorbante qui est disposée dans le revêtement diélectrique entre deux couches diélectriques, la matière absorbante des couches absorbantes étant majoritairement dans le revêtement diélectrique sous-jacent à la couche fonctionnelle métallique ou majoritairement dans le revêtement diélectrique sus-jacent à la couche fonctionnelle métallique de telle sorte que :

- soit la matière absorbante de toutes les couches absorbantes (c'est-à-dire l'épaisseur physique de la matière absorbante) est majoritairement dans le revêtement diélectrique sous-jacent à la couche fonctionnelle métallique et l'empilement de couches minces est positionné sur la face intérieure du substrat en contact sur une autre face avec l'espace extérieur ;
- soit la matière absorbante de toutes les couches absorbantes (c'est-à-dire l'épaisseur physique de la matière absorbante) est majoritairement dans le revêtement diélectrique sus-jacent à la couche fonctionnelle métallique et l'empilement de couches minces est positionné sur la face intérieure du substrat en contact sur une autre face avec l'espace intérieur.

De préférence, un seul substrat du vitrage multiple comportant au moins deux substrats ou du vitrage multiple comportant au moins trois substrats est revêtu sur une face intérieure en contact avec la lame de gaz intercalaire d'un empilement de couches minces à propriétés de réflexion dans l'infrarouge et/ou dans le rayonnement solaire.

Par « majoritairement » au sens de la présente invention, il faut comprendre que plus de la moitié de l'épaisseur totale de la matière absorbante de la (ou des) couche(s) absorbante(s) de l'empilement est située soit dans le revêtement diélectrique sous-jacent à la couche fonctionnelle métallique, soit dans le revêtement diélectrique sus-jacent à la couche fonctionnelle métallique.

Dans une variante particulière, « majoritairement » peut ainsi désigner une épaisseur physique comprise entre plus de 50 % et moins de 100 %, voire comprise entre 55 % et 95 % en incluant ces valeurs, voire comprise entre 60 % et 90 % en incluant ces valeurs.

Dans le cadre de l'invention la matière absorbante présente dans l'empilement ailleurs qu'à l'intérieur des revêtements diélectriques n'est pas prise en considération pour l'interprétation du mot « majoritairement » ; ainsi, la (ou les) couche(s) de blocage éventuellement présente(s) et qui est (ou sont) en contact ou à proximité de la couche fonctionnelle ne fait (ou ne font) pas partie de la matière absorbante prise en considération pour l'interprétation du mot « majoritairement ».

Par « revêtement » au sens de la présente invention, il faut comprendre qu'il peut y avoir une seule couche ou plusieurs couches de matériaux différents à l'intérieur du revêtement.

Comme habituellement, par « couche diélectrique » au sens de la présente invention, il faut comprendre que du point de vue de sa nature, le matériau est « non métallique », c'est-à-dire n'est pas un métal. Dans le contexte de l'invention, ce terme désigne un matériau présentant un rapport n/k sur toute la plage de longueur d'onde du visible (de 380 nm à 780 nm) égal ou supérieur à 5.

Par « matière absorbante » au sens de la présente invention, il faut comprendre un matériau présentant un rapport n/K sur toute la plage de longueur d'onde du visible (de 380 nm à 780 nm) entre 0 et 5 en excluant ces valeurs et présentant une résistivité électrique à l'état massif (telle que connue dans la littérature) supérieure à $10^{-5}$ $\Omega$.cm.

Il est rappelé que n désigne l'indice de réfraction réel du matériau à une longueur d'onde donnée et k représente la partie imaginaire de l'indice de réfraction à une longueur d'onde donnée ; le rapport n/k étant calculé à une longueur d'onde donnée identique pour n et pour k.

A l'intérieur de chaque revêtement diélectrique, les deux couches diélectriques qui encadrent une couche absorbante sont, de préférence, de même nature : la composition (stoechiométrie) des couches diélectriques est ainsi identique de chaque côté de la couche absorbante.

Dans une version particulière de l'invention au moins un substrat comporte sur au moins une face en contact avec une lame de gaz intercalaire un revêtement antireflet qui est en vis-à-vis par rapport à ladite lame de gaz intercalaire avec un empilement de couches minces à propriétés de réflexion dans l'infrarouge et/ou dans le rayonnement solaire.

Cette version permet d'atteindre une sélectivité encore plus grande, grâce à une augmentation significative de la transmission lumineuse et à une augmentation moindre du facteur solaire du vitrage multiple.

Dans une autre version particulière de l'invention, l'épaisseur (physique) totale e de la (ou de toutes les) couche(s) absorbante(s) de l'empilement de couche minces positionné sur la face intérieure du premier substrat traversé par le rayonnement solaire incident, en nanomètres, est telle que : $e = a \times e_{140} + 55 - FS$ avec :

$$0,5 \ nm < e < 10 \ nm, \ voire \ 2 < e < 8 \ nm$$

$$-1,5 < a < 0$$

$e_{140}$, épaisseur physique de la couche d'argent : $5 \ nm \leq e_{140} \leq 20 \ nm$ et
FS, le facteur solaire en % du vitrage multiple.

Dans une version particulière de l'invention, au moins une couche absorbante de l'empilement, et de préférence toutes les couches absorbantes de l'empilement, est ou sont à base de nitrure et en particulier au moins une couche de ces couches et de préférence toutes ces couches est (ou sont) à base de nitrure de niobium NbN, ou au moins une couche de ces couches et de préférence toutes ces couches est (ou sont) à base de nitrure de titane TiN.

Ladite (ou chaque) couche absorbante présente, de préférence, une épaisseur comprise entre 0,5 et 10 nm, en incluant ces valeurs, voire entre 2 et 8 nm, en incluant ces valeurs afin de conserver une transmission lumineuse égale ou supérieure à 25%, voire égale ou supérieure à 30 % en vitrage multiple.

La couche diélectrique qui est au minimum comprise dans chaque revêtement diélectrique, comme défini ci-avant, présente un indice optique compris entre 1,8 et 2,5 en incluant ces valeurs, ou, de préférence, entre 1,9 et 2,3 en incluant ces valeurs (les indices optiques - ou « indices de réfraction » - indiqués ici sont ceux mesurés à 550 nm, comme habituellement).

Dans une variante particulière, lesdits revêtements diélectrique sous-jacent et diélectrique sus-jacent comportent chacun au moins une couche diélectrique à base de nitrure de silicium, éventuellement dopé à l'aide d'au moins un autre élément, comme l'aluminium.

Dans une variante particulière de l'invention, chaque couche absorbante est disposée dans le revêtement diélectrique entre deux couches diélectrique qui sont toutes les deux à base de nitrure de silicium, éventuellement dopé à l'aide d'au moins un autre élément, comme l'aluminium.

Dans une variante particulière, la dernière couche du revêtement diélectrique sous-jacent, celle la plus éloignée du substrat, est une couche de mouillage à base d'oxyde, notamment à base d'oxyde de zinc, éventuellement dopé à l'aide d'au moins un autre élément, comme l'aluminium.

Dans une variante toute particulière, le revêtement diélectrique sous-jacent comprend au moins une couche diélectrique à base de nitrure, notamment de nitrure de silicium et/ou de nitrure d'aluminium et au moins une couche de lissage non cristallisée en un oxyde mixte, ladite couche de lissage étant en contact avec une couche de mouillage sus-jacente cristallisée.

De préférence, la couche fonctionnelle est déposée directement sur un revêtement de sous-blocage disposé entre la couche fonctionnelle et le revêtement diélectrique sous-jacent à la couche fonctionnelle et/ou la couche fonctionnelle est déposée directement sous un revêtement de sur-blocage disposé entre la couche fonctionnelle et le revêtement diélectrique sus-jacent à la couche fonctionnelle et le revêtement de sous-blocage et/ou le revêtement de sur-blocage comprend une couche fine à base de nickel ou de titane présentant une épaisseur géométrique e telle que $0,2 \ nm \leq e \leq 2,5 \ nm$.

Par ailleurs, le revêtement de sous-blocage et/ou le revêtement de sur-blocage peut comprendre au moins une couche fine à base de nickel ou de titane présent sous forme métallique si le substrat muni de l'empilement de couches minces n'a pas subi de traitement thermique de bombage et/ou trempe après le dépôt de l'empilement, cette couche étant au moins partiellement oxydée si le substrat muni de l'empilement de couches minces a subi au moins un traitement thermique de bombage et/ou trempe après le dépôt de l'empilement.

La couche fine à base de nickel du revêtement de sous-blocage et/ou la couche fine à base de nickel du revêtement de sur-blocage lorsqu'elle est présente est, de préférence, directement au contact de la couche fonctionnelle.

Dans une variante particulière, la dernière couche du revêtement diélectrique sus-jacent, celle la plus éloignée du substrat, est à base d'oxyde, déposée de préférence sous stoechiométrique, et notamment est à base de titane ($TiO_x$) ou à base d'oxyde mixte de zinc et d'étain ($SnZnO_x$, éventuellement par un autre élément à raison de 10 % en masse au maximum.

L'empilement peut ainsi comporter une dernière couche (« overcoat » en anglais), c'est-à-dire une couche de protection, déposée de préférence sous stoechiométrique. Cette couche se retrouve oxydée pour l'essentiel stoechiométriquement dans l'empilement après le dépôt.

Cette couche de protection présente, de préférence, une épaisseur comprise entre 0,5 et 10 nm.

Le vitrage selon l'invention incorpore au moins le substrat porteur de l'empilement selon l'invention, éventuellement associé à au moins un autre substrat. Chaque substrat peut être clair ou coloré. Un des substrats au moins notamment peut être en verre coloré dans la masse. Le choix du type de coloration va dépendre du niveau de transmission lumineuse et/ou de l'aspect colorimétrique recherchés pour le vitrage une fois sa fabrication achevée.

Le vitrage selon l'invention peut présenter une structure feuilletée, associant notamment au moins deux substrats rigides du type verre par au moins une feuille de polymère thermoplastique, afin de présenter une structure de type verre/empilement de couches minces/feuille(s)/verre / lame de gaz intercalaire / feuille de verre. Le polymère peut notamment être à base de polyvinylbutyral PVB, éthylène vinylacétate EVA, polyéthylène téréphtalate PET, polychlorure de vinyle PVC.

Les substrats des vitrages selon l'invention sont aptes à subir un traitement thermique sans dommage pour l'empilement de couches minces. Ils sont donc éventuellement bombés et/ou trempés.

L'invention concerne également le procédé de fabrication des vitrages multiples selon l'invention comportant au moins deux substrats qui sont maintenus ensemble par une structure de châssis, ledit vitrage réalisant une séparation entre un espace extérieur et un espace intérieur, dans lequel au moins une lame de gaz intercalaire est disposée entre les deux substrats, un substrat étant revêtu sur une face intérieure en contact avec la lame de gaz intercalaire d'un empilement de couches minces à propriétés de réflexion dans l'infrarouge et/ou dans le rayonnement solaire comportant une seule couche fonctionnelle métallique, en particulier à base d'argent ou d'alliage métallique contenant de l'argent et deux revêtements diélectriques, lesdits revêtements comportant chacun au moins une couche diélectrique, ladite couche fonctionnelle étant disposée entre les deux revêtements diélectriques, les deux revêtements diélectriques comportant une couche absorbante qui est disposée dans le revêtement diélectrique entre deux couches diélectriques, la matière absorbante des couches absorbantes étant majoritairement dans le revêtement diélectrique sous-jacent à la couche fonctionnelle métallique ou majoritairement dans le revêtement diélectrique sus-jacent à la couche fonctionnelle métallique de telle sorte que :

- soit le substrat est positionné dans la structure de châssis pour que sa face intérieure comporte un empilement de couches minces dont la matière absorbante de toutes les couches absorbantes est majoritairement dans le revêtement diélectrique sous-jacent à la couche fonctionnelle métallique et que son autre face soit en contact avec l'espace extérieur ;
- soit le substrat est positionné dans la structure de châssis pour que sa face intérieure comporte un empilement de couches minces dont la matière absorbante de toutes les couches absorbantes est majoritairement dans le revêtement diélectrique sus-jacent à la couche fonctionnelle métallique et que son autre face soit en contact avec l'espace intérieur.

Lorsque deux couches diélectriques qui encadre une couche absorbante sont déposées par pulvérisation cathodique réactive en présence d'azote et/ou d'oxygène, alors la couche absorbante déposée entre ces deux couches est, de préférence, également déposée respectivement en présence d'azote et/ou d'oxygène.

L'invention concerne en outre l'utilisation d'un empilement de couches minces à propriétés de réflexion dans l'infrarouge et/ou dans le rayonnement solaire comportant une seule couche fonctionnelle métallique, en particulier à base d'argent ou d'alliage métallique contenant de l'argent et deux revêtements diélectriques, lesdits revêtements comportant chacun au moins une couche diélectrique, ladite couche fonctionnelle étant disposée entre les deux revêtements diélectriques et ledit empilement de couches minces étant disposé sur une face intérieure d'au moins un substrat pour réaliser un vitrage multiple selon l'invention comportant au moins deux substrats, qui sont maintenus ensemble par une structure de châssis et dans lequel une lame de gaz intercalaire est disposée deux substrats.

Avantageusement, la présente invention permet ainsi de réaliser un empilement de couches minces monocouche fonctionnelle présentant dans une configuration vitrage multiple, et notamment double vitrage, une sélectivité importante (S $\geq$ 1,40), une faible émissivité ($\varepsilon_N \leq 3$ %) et une esthétique favorable ($T_{Lvis} \geq 60$ %, $R_{Lvis}$ extérieure $\leq 25$ % voire $R_{Lvis}$ extérieure $\leq 20$ % ou même $R_{Lvis}$ extérieure $< 20$ %, couleurs neutres en réflexion extérieure), alors que jusqu'ici, seuls des empilements bicouches fonctionnelles permettaient d'obtenir cette combinaison de critères.

L'empilement monocouche fonctionnelle selon l'invention coûte moins cher à produire qu'un empilement bicouches fonctionnelles présentant des caractéristiques similaires ($T_{Lvis}$, $R_{Lvis}$ et couleurs neutres en réflexion extérieure).

Les détails et caractéristiques avantageuses de l'invention ressortent des exemples non limitatifs suivants, illustrés à l'aide des figures ci-jointes illustrant :

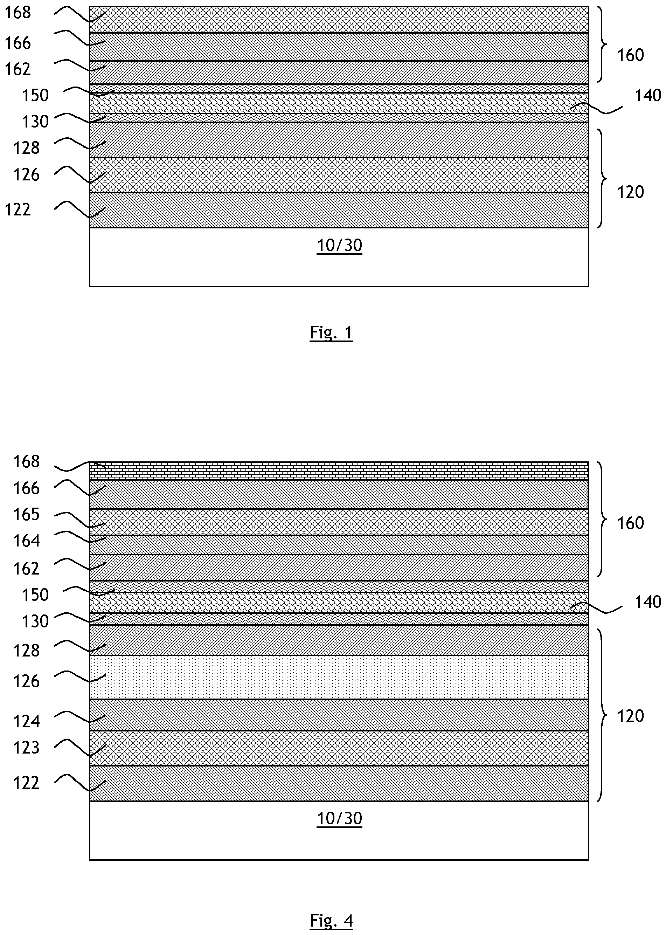

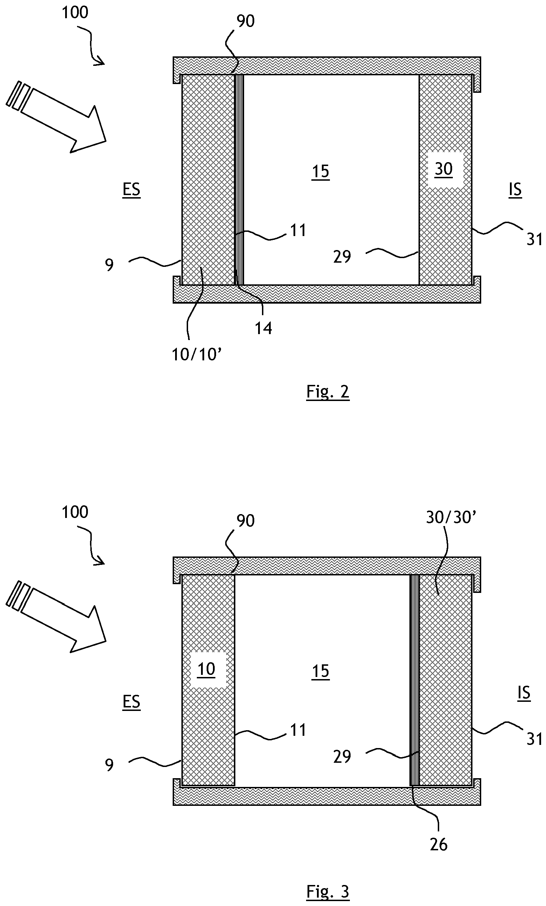

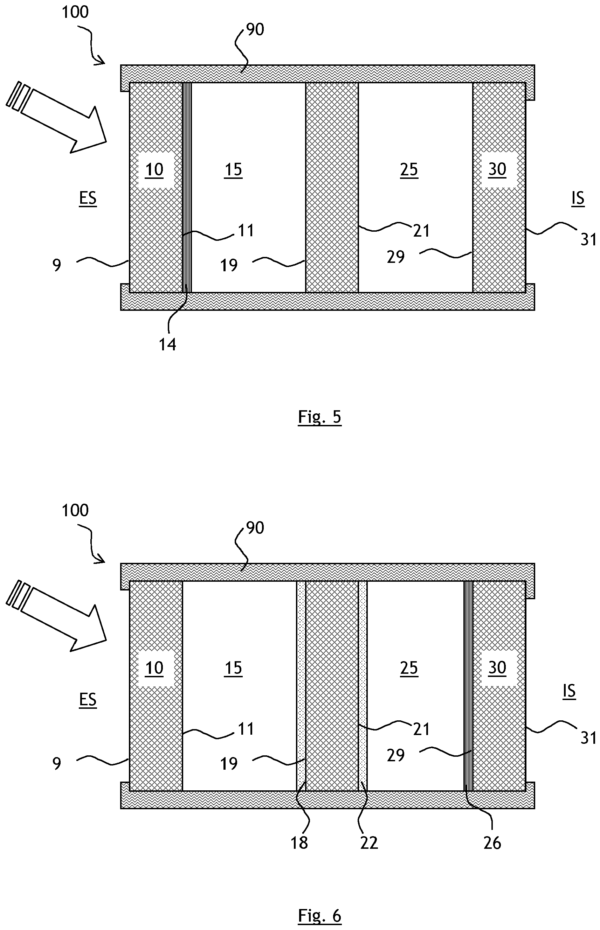

- en figure 1, un empilement monocouche fonctionnelle de l'art antérieur, la couche fonctionnelle étant pourvue d'un revêtement de sous-blocage et d'un revêtement de sur-blocage ;
- en figures 2 et 3, deux solutions de double vitrage incorporant un empilement monocouche fonctionnelle ;
- en figure 4, un empilement monocouche fonctionnelle selon l'invention, la couche fonctionnelle étant pourvue d'un revêtement de sous-blocage et d'un revêtement de sur-blocage ; et
- en figures 5 et 6, deux solutions de triple vitrage incorporant un empilement monocouche fonctionnelle.

Dans ces figures, les proportions entre les épaisseurs des différentes couches ou des différents éléments ne sont pas rigoureusement respectées afin de faciliter leur lecture.

La figure 1 illustre une structure d'un empilement monocouche fonctionnelle de l'art antérieur déposé sur un substrat 10, 30 verrier, transparent, dans laquelle la couche fonctionnelle 140 unique, en particulier à base d'argent ou d'alliage métallique contenant de l'argent, est disposée entre deux revêtements diélectriques, le revêtement diélectrique sous-jacent 120 situé en dessous de la couche fonctionnelle 140 en direction du substrat 10/30 et le revêtement diélectrique sus-jacent 160 disposé au-dessus de la couche fonctionnelle 140 à l'opposé du substrat 10/30.

Ces deux revêtements diélectrique 120, 160, comportent chacun au moins deux couches diélectriques 122, 126, 128 ; 162, 166, 168.

Eventuellement, d'une part la couche fonctionnelle 140 peut être déposée sur un revêtement de sous-blocage 130 disposé entre le revêtement diélectrique sous-jacent 120 et la couche fonctionnelle 140 et d'autre part la couche fonctionnelle 140 peut être déposée directement sous un revêtement de sur-blocage 150 disposé entre la couche fonctionnelle 140 et le revêtement diélectrique sus-jacent 160.

Ce revêtement diélectrique 160 peut se terminer par une couche de protection optionnelle 168, en particulier à base d'oxyde, notamment sous stoechiométrique en oxygène.

Lorsqu'un empilement monocouche fonctionnelle est utilisé dans un vitrage multiple 100 de structure double vitrage, ce vitrage comporte deux substrats 10, 30 qui sont maintenus ensemble par une structure de châssis 90 et qui sont séparés l'un de l'autre par une lame de gaz intercalaire 15.

Le vitrage réalise ainsi une séparation entre un espace extérieur ES et un espace intérieur IS.

L'empilement peut être positionné en face 2 (sur la feuille de verre la plus à l'extérieur du bâtiment en considérant le sens incident de la lumière solaire entrant dans le bâtiment et sur sa face tournée vers la lame de gaz) ou en face 3 (sur la feuille la plus à l'intérieur du bâtiment en considérant le sens incident de la lumière solaire entrant dans le bâtiment et sur sa face tournée vers la lame de gaz).

Les figures 2 et 3 illustrent respectivement le positionnement (le sens incident de la lumière solaire entrant dans le bâtiment étant illustré par la double flèche) :

- en face 2 d'un empilement de couches minces 14 positionné sur une face intérieure 11 du substrat 10 en contact avec la lame de gaz intercalaire 15, l'autre face 9 du substrat 10 étant en contact avec l'espace extérieur ES ; et
- en face 3 d'un empilement de couches minces 26 positionné sur une face intérieure 29 du substrat 30 en contact avec la lame de gaz intercalaire 15, l'autre face 31 du substrat 30 étant en contact avec l'espace intérieur IS.

Toutefois, il peut aussi être envisagé que dans cette structure de double vitrage, l'un des substrats présente une structure feuilletée ; toutefois, il n'y a pas de confusion possible car dans une telle structure, il n'y a pas de lame de gaz intercalaire.

En outre, il peut être prévu, bien que cela ce soit pas illustré, qu'au moins un substrat 10, 30 comporte sur au moins une face 11 (dans le cas de la figure 3), 29 (dans le cas de la figure 2) en contact avec la lame de gaz intercalaire 15 et qui ne comporte pas d'empilement de couches minces à propriétés de réflexion dans l'infrarouge et/ou dans le rayonnement solaire, un revêtement antireflet qui est en vis-à-vis par rapport à ladite lame de gaz intercalaire 15 avec l'empilement de couches minces 14 (dans le cas de la figure 2), 26 (dans le cas de la figure 3) à propriétés de réflexion dans l'infrarouge et/ou dans le rayonnement solaire.

Le but de cette insertion d'un revêtement antireflet dans une structure de double vitrage est de permettre d'obtenir une transmission lumineuse élevée et un facteur solaire élevé.

Une série de cinq exemples a été réalisée, chaque exemple étant numéroté de 1 à 5.

Conformément à l'enseignement de la demande internationale de brevet N° WO 2007/101964, le revêtement diélectrique sous-jacent 120 peut comprendre une couche diélectrique 122 à base de nitrure de silicium et au moins une couche de lissage 126 non cristallisée en un oxyde mixte, en l'occurrence un oxyde mixte de zinc et d'étain qui est ici dopé à l'antimoine (déposé à partir d'une cible métallique constitué des rapports massiques 65:34:1 respectivement pour Zn:Sn:Sb), ladite couche de lissage 126 étant en contact avec une couche de mouillage 128 sus-jacente.

Dans cet empilement, la couche de mouillage 128 en oxyde de zinc dopé à l'aluminium ZnO:Al (déposé à partir d'une cible métallique constitué de zinc dopé à 2 % en masse d'aluminium) permet d'améliorer la cristallisation de l'argent, ce qui améliore sa conductivité ; cet effet est accentué par l'emploi de la couche de lissage amorphe de $SnZnO_x$:Sb, qui améliore la croissance de ZnO et donc de l'argent.

Le revêtement diélectrique sus-jacent 160 peut comprendre au moins une couche diélectrique 162 en oxyde de zinc dopé à l'aluminium ZnO:Al (déposé à partir d'une cible métallique constitué de zinc dopé à 2 % en masse d'aluminium) et une couche diélectrique 166 à base de nitrure de silicium.

Les couches en nitrure de silicium 122, 166 sont en $Si_3N_4$ et sont déposées à partir d'une cible métallique dopée à 8 % en masse d'aluminium.

Ces empilements présentent de plus l'avantage d'être trempables, c'est-à-dire qu'ils résistent à un traitement thermique de trempe et que leurs propriétés optiques varient peu lors de ce traitement thermique.

Pour tous les exemples ci-après, les conditions de dépôt des couches sont :

| Couche | Cible employée | Pression de dépôt | Gaz |
|---|---|---|---|
| $Si_3N_4$ | Si:Al à 92:8 % wt | $1,5.10^{-3}$ mbar | Ar /(Ar + N2) à 45 % |
| NbN | Nb | $1,5.10^{-3}$ mbar | Ar /(Ar + N2) à 45 % |
| SnZnO | SnZn:Sb à 34:65:1 wt | $2.10^{-3}$ mbar | Ar /(Ar + O2) à 58 % |
| ZnO | Zn:Al à 98:2 % wt | $2.10^{-3}$ mbar | Ar /(Ar + O2) à 52 % |
| NiCr | NiCr à 80:20 wt | $2.10^{-3}$ mbar | Ar à 100 % |
| Ag | Ag | $2.10^{-3}$ mbar | Ar à 100 % |

Les couches déposées peuvent ainsi être classées en trois catégories :

i- couches en matériau diélectrique, présentant un rapport n/k sur toute la plage de longueur d'onde du visible supérieur en 5 : $Si_3N_4$, SnZnO, ZnO

ii- couches en matériau absorbant, présentant un rapport 0 < n/k < 5 sur toute la plage de longueur d'onde du visible et une résistivité électrique à l'état massif est supérieure à $10^{-5}$ $\Omega$.cm : NbN

iii- couches fonctionnelles métalliques en matériau à propriétés de réflexion dans l'infrarouge et/ou dans le rayonnement solaire : Ag.

Il a été constaté que l'argent présente aussi un rapport 0 < n/k < 5 sur toute la plage de longueur d'onde du visible, mais sa résistivité électrique à l'état massif est inférieure à $10^{-5}$ $\Omega$.cm.

Il a été constaté en outre que les matériaux : Ti, NiCr, TiN, Nb peuvent constituer des couches en matériau absorbant selon la définition donnée ici.

Dans tous les exemples ci-après l'empilement de couches minces est déposé sur un substrat en verre sodo-calcique clair d'une épaisseur de 4 mm de la marque Planilux, distribué par la société SAINT-GOBAIN.

Pour ces substrats,

- R indique : la résistance par carré de l'empilement, en ohms par carré ;
- $T_L$ indique : la transmission lumineuse dans le visible en %, mesurée selon l'illuminant D65 à 2° ;
- $a_T$* et $b_T$* indiquent : les couleurs en transmission a* et b* dans le système LAB mesurées selon l'illuminant D65 à 2° ;
- $R_c$ indique : la réflexion lumineuse dans le visible en %, mesurée selon l'illuminant D65 à 2°, côté du substrat revêtu de l'empilement de couches minces ;
- $a_c$* et $b_c$* indiquent : les couleurs en transmission a* et b* dans le système LAB mesurées selon l'illuminant D65 à 2°, côté du substrat revêtu ;
- $R_g$ indique : la réflexion lumineuse dans le visible en %, mesurée selon l'illuminant D65 à 2°, côté du substrat nu ;
- $a_g$* et $b_g$* indiquent : les couleurs en transmission a* et b* dans le système LAB mesurées selon l'illuminant D65 à 2°, côté du substrat nu.

Par ailleurs, pour ces exemples, dans tous les cas où un traitement thermique a été appliqué au substrat, il s'agissait d'un recuit pendant environ 6 minutes à une température d'environ 620°C suivi d'un refroidissement à l'air ambiant (environ 20°C), afin de simuler un traitement thermique de bombage ou de trempe.

En outre, pour ces exemples, lorsque le substrat porteur de l'empilement est intégré dans un double vitrage, celui-ci présente la structure : 4-16-4 (Ar - 90%), c'est-à-dire que deux substrats en verre, chacun d'une épaisseur de 4 mm sont séparés par une lame de gaz constituée à 90 % d'argon et 10% d'air présentant une épaisseur de 16 mm.

Tous ces exemples ont permis d'atteindre, dans cette configuration de double vitrage, un coefficient U, ou coefficient K, calculé selon la norme EN 673, de l'ordre de 1,1 W.m$^{-2}$.°K$^{-1}$ (c'est le coefficient de transmission thermique à travers le vitrage ; il désigne la quantité de chaleur traversant le substrat en régime stationnaire, par unité de surface et pour une différence de température unitaire entre la face du vitrage en contact avec l'espace extérieur et la face du vitrage en contact avec l'espace intérieur).

Pour ces double-vitrages,

- FS indique : le facteur solaire, c'est-à-dire le rapport, en pourcent, de l'énergie solaire totale entrant dans le local à travers le vitrage sur l'énergie solaire incidente totale ;
- s indique : la sélectivité correspondant au rapport de la transmission lumineuse $T_L$ dans le visible sur le facteur solaire FS tel que : $S = T_{Lvis} / FS$ ;
- $T_L$ indique : la transmission lumineuse dans le visible en %, mesurée selon l'illuminant D65 à 2° ;
- $a_T^*$ et $b_T^*$ indiquent : les couleurs en transmission a* et b* dans le système LAB mesurées selon l'illuminant D65 à 2° ;
- $R_e$ indique : la réflexion lumineuse extérieure dans le visible en %, mesurée selon l'illuminant D65 à 2°, côté espace extérieur ES ;
- $a_e^*$ et $b_e^*$ indiquent : les couleurs en réflexion extérieure a* et b* dans le système LAB mesurées selon l'illuminant D65 à 2°, côté espace extérieur ES ;
- $R_i$ indique : la réflexion lumineuse intérieure dans le visible en %, mesurée selon l'illuminant D65 à 2°, côté espace intérieur IS ;
- $a_i^*$ et $b_i^*$ indiquent : les couleurs en réflexion intérieure a* et b* dans le système LAB mesurées selon l'illuminant D65 à 2°, côté espace intérieur IS.

Un exemple N°1 a été réalisé selon la structure d'empilement illustré en figure 1, sans couche absorbante au sens de l'invention et sans toutefois de couche de protection optionnelle 168, ni de revêtement de sous-blocage 130.

Le tableau 1 ci-après illustre les épaisseurs géométriques ou physiques (et non pas les épaisseurs optiques) en nanomètres de chacune des couches de l'exemple 1 :

Tableau 1

| Couche | Matériau | Ex. 1 |
|---|---|---|
| 166 | Si$_3$N$_4$:Al | 32 |
| 162 | ZnO:Al | 20 |
| 150 | NiCr | 1 |
| 140 | Ag | 15 |
| 128 | ZnO:Al | 4 |
| 126 | SnZnO$_x$:Sb | 5 |
| 122 | Si$_3$N$_4$:Al | 21 |

Le tableau 2 ci-après résume les principales caractéristiques optiques et énergétique de cet exemple 1, respectivement lorsque l'on considère uniquement le substrat 10/30 seul avant traitement thermique, le substrat 10'/30' seul après un traitement thermique et lorsque ceux-ci sont monté en double vitrage, en face 2, F2, comme en figure 2 et en face 3, F3, comme en figure 3.

Pour les deux lignes F2, la ligne du haut indique les données obtenues avec le substrat 10 et la ligne du bas indique les données obtenues avec le substrat 10' ayant subi un traitement thermique ; de mêmes, pour les deux lignes F3, la ligne du haut indique les données obtenues avec le substrat sans traitement thermique, (qui est alors le substrat 30) et la ligne du bas indique les données obtenues avec le substrat ayant subi un traitement thermique (qui est alors le substrat 30').

Tableau 2

|  | R | | $T_L$ | $a_T^*$ | $b_T^*$ | $R_c$ | $a_c^*$ | $b_c^*$ | $R_g$ | $a_g^*$ | $b_g^*$ |
|---|---|---|---|---|---|---|---|---|---|---|---|
| 10 | 2,9 | | 71,3 | -2,9 | 5,4 | 18,1 | 2,9 | -13,2 | 21,6 | 0,8 | -10,4 |
| 10' | 2,3 | | 73,5 | -3,5 | 4,0 | 18,9 | 5,0 | -10,7 | 20,9 | 3,0 | -9,0 |
|  | FS | s | $T_L$ | $a_T^*$ | $b_T^*$ | $R_e$ | $a_e^*$ | $b_e^*$ | $R_i$ | $a_i^*$ | $b_i^*$ |
| F2 | 44,1 | 1,47 | 64,8 | -3,8 | 5,3 | 26,1 | -0,8 | -7,1 | 23,3 | 0 | -8,9 |
|  | 44,8 | 1,49 | 66,6 | -4,3 | 4,1 | 25,5 | 1,1 | -6,4 | 23,6 | 1,5 | -7,0 |
| F3 | 50,0 | 1,30 | 64,8 | -3,8 | 5,3 | 23,3 | 0 | -8,9 | 26,1 | -0,8 | -7,1 |
|  | 48,9 | 1,36 | 66,6 | -4,3 | 4,1 | 23,6 | 1,5 | -7,0 | 25,5 | 1,1 | -6,4 |

Ainsi, comme visible dans ce tableau 2, la transmission lumineuse dans le visible $T_L$ du vitrage est de l'ordre de 65 % et la couleur en réflexion extérieure est relativement neutre.

Toutefois, la réflexion lumineuse extérieure $R_e$ ne donne pas complètement satisfaction, dans le sens où elle peut paraître trop élevée, tant en face 2 qu'en face 3 et il est alors souhaitable de la diminuer, à une valeur égale ou inférieure à 20 %, voire à une valeur égale ou inférieure à 15 %, sans que les autres paramètres et en particulier les paramètres de couleur, ne soient affectés.

Des exemples, numérotés 2 à 5, ont ensuite été réalisés sur la base de l'empilement illustré en figure 4, en insérant dans l'empilement une (ou plusieurs) couche(s) absorbante(s) en nitrure de Niobium NbN.

Le tableau 3 ci-après illustre les épaisseurs géométriques en nanomètres de chacune des couches de l'exemple 2 :

Tableau 3

| Couche | Matériau | Ex. 2 |
|---|---|---|
| 166 | $Si_3N_4$:Al | 34 |
| 162 | ZnO:Al | 10 |
| 150 | NiCr | 1 |
| 140 | Ag | 15 |
| 128 | ZnO:Al | 6 |
| 126 | $SnZnO_x$:Sb | 16 |
| 124 | $Si_3N_4$:Al | 13 |
| 123 | NbN | 4,5 |
| 122 | $Si_3N_4$:Al | 13 |

Cet exemple 2 est ainsi sensiblement identique à l'exemple 1 sauf en ce que la couche diélectrique 122 a été séparée en deux parties d'épaisseurs sensiblement identiques (respectivement 122 et 124) et en ce qu'une couche absorbante 123 a été insérée entre ces deux couches, c'est-à-dire sensiblement au milieu de la couche 122 de l'exemple 1.

Le tableau 4 ci-après résume les principales caractéristiques optiques et énergétique de cet exemple 2, respectivement lorsque l'on considère uniquement le substrat et lorsque celui-ci est monté en double vitrage, en face 2, comme en figure 2 et en face 3, comme en figure 3. Ce tableau présente la même structure que le tableau 2.

Tableau 4

|  | R | | $T_L$ | $a_T^*$ | $b_T^*$ | $R_c$ | $a_c^*$ | $b_c^*$ | $R_g$ | $a_g^*$ | $b_g^*$ |
|---|---|---|---|---|---|---|---|---|---|---|---|
| 10 | 2,8 | | 52,3 | -6,4 | 0,9 | 17,9 | 14,5 | 4 | 5,1 | 4,1 | -4,6 |
| 10' | 2,3 | | 53,4 | -6,9 | -0,3 | 20 | 13,4 | 6,4 | 5,1 | 5,1 | -4,6 |
|  | FS (%) | s | $T_L$ | $a_T^*$ | $b_T^*$ | $R_e$ | $a_e^*$ | $b_e^*$ | $R_i$ | $a_i^*$ | $b_i^*$ |

**EP 2 379 463 B1**

(suite)

|   | R |   | $T_L$ | $a_T^*$ | $b_T^*$ | $R_c$ | $a_c^*$ | $b_c^*$ | $R_g$ | $a_g^*$ | $b_g^*$ |
|---|---|---|---|---|---|---|---|---|---|---|---|
| F2 | 33,7 | 1,41 | 47,6 | -6,9 | 1,2 | 7,4 | 1,2 | -3,6 | 22,6 | 9 | 2,6 |
|    | 34,3 | 1,42 | 48,6 | -7,3 | -0,1 | 7,5 | 1,9 | -3,9 | 24,3 | 8,5 | 4,3 |
| F3 | 47,6 | 1,41 | 47,6 | -6,9 | 1,2 | 22,6 | 9 | 2,6 | 7,4 | 1,2 | -3,6 |
|    | 48,6 | 1,42 | 48,6 | -7,3 | -0,1 | 24,3 | 8,5 | 4,3 | 7,5 | 1,9 | -3,9 |

Comme visible dans ce tableau 4, la réflexion lumineuse extérieure $R_e$ est très satisfaisante lorsque l'empilement est positionné en face 2 : elle est de l'ordre de 7,5 % ; elle n'est par contre pas satisfaisante lorsque l'empilement est positionné en face 3.

Par ailleurs, la couleur vue de l'extérieur, est peu différente de celle de l'exemple 1 et reste neutre, que l'empilement ait subi ou non un traitement thermique.

L'épaisseur totale e de couche absorbante 123 dans l'empilement en nanomètres est telle que, en application de la formule e = a x $e_{40}$ + 55 - FS, en double-vitrage face 2 : a = - 1,1.

Le tableau 5 ci-après illustre les épaisseurs géométriques en nanomètres de chacune des couches de l'exemple 3 :

Tableau 5

| Couche | Matériau | Ex. 3 |
|---|---|---|
| 166 | $Si_3N_4$:Al | 43 |
| 165 | NbN | 3,5 |
| 164 | $Si_3N_4$:Al | 4 |
| 162 | ZnO:Al | 10 |
| 150 | NiCr | 1 |
| 140 | Ag | 15 |
| 128 | ZnO:Al | 8 |
| 126 | $SnZnO_x$:Sb | 6 |
| 122 | $Si_3N_4$:Al | 14 |

Cet exemple 3 est ainsi sensiblement identique à l'exemple 1 sauf en ce que la couche diélectrique 166 a été séparée en deux parties d'épaisseur sensiblement identique (respectivement 164 et 166) et en ce qu'une couche absorbante 165 a été insérée entre ces deux couches, c'est-à-dire sensiblement au milieu de la couche 166 de l'exemple 1.

Le tableau 6 ci-après résume les principales caractéristiques optiques et énergétique de cet exemple 3, respectivement lorsque l'on considère uniquement le substrat et lorsque celui-ci est monté en double vitrage, en face 2, comme en figure 2 et en face 3, comme en figure 3. Ce tableau présente la même structure que les tableaux 2 et 4.

Tableau 6

|   | R |   | $T_L$ | $a_T^*$ | $b_T^*$ | $R_c$ | $a_c^*$ | $b_c^*$ | $R_g$ | $a_g^*$ | $b_g^*$ |
|---|---|---|---|---|---|---|---|---|---|---|---|
| 10 | 2,7 | | 51,8 | -1,8 | 1,9 | 8 | -0,7 | -21,1 | 31,5 | -1,4 | -5,6 |
| 10' | 2,6 | | 52,5 | -2 | 1,3 | 8,5 | 0,7 | -19,9 | 31,6 | -0,7 | -5,6 |
|   | FS (%) | s | $T_L$ | $a_T^*$ | $b_T^*$ | $R_e$ | $a_e^*$ | $b_e^*$ | $R_i$ | $a_i^*$ | $b_i^*$ |
| F2 | 35 | 1,33 | 46,7 | -2,7 | 1,6 | 33,7 | -1,6 | -5,2 | 14,6 | -1,3 | -13,1 |
|    | 35,1 | 1,35 | 47,4 | -2,9 | 1,1 | 33,9 | -1 | -5,3 | 15 | -0,5 | -12,4 |
| F3 | 561 | 0,83 | 46,7 | -2,7 | 1,6 | 14,6 | -1,3 | -13,1 | 33,7 | -1,6 | -5,2 |
|    | 56,6 | 0,84 | 47,4 | -2,9 | 1,1 | 15 | -0,5 | -12,4 | 33,9 | -1 | -5,3 |

Comme visible dans ce tableau 6, la réflexion lumineuse extérieure $R_e$ est très satisfaisante lorsque l'empilement est positionné en face 3 : elle est de l'ordre de 15 % ; elle n'est par contre pas satisfaisante lorsque l'empilement est positionné en face 2.

Par ailleurs, la couleur vue de l'extérieur, est peu différente de celle de l'exemple 1 et reste neutre, que l'empilement ait subi ou non un traitement thermique.

L'épaisseur totale e de couche absorbante 165 dans l'empilement en nanomètres est telle que, en application de la formule $e = a \times e_{40} + 55 - FS$, en double-vitrage face 2 : a = - 1,1.

Le tableau 7 ci-après illustre les épaisseurs géométriques en nanomètres de chacune des couches de l'exemple 4 :

Tableau 7

| Couche | Matériau | Ex. 4 |
|--------|----------|-------|
| 166 | $Si_3N_4$:Al | 12 |
| 165 | NbN | 1 |
| 164 | $Si_3N_4$:Al | 18 |
| 162 | ZnO:Al | 9 |
| 150 | NiCr | 1 |
| 140 | Ag | 12 |
| 128 | ZnO:Al | 10 |
| 126 | $SnZnO_x$:Sb | 5 |
| 124 | $Si_3N_4$:Al | 15 |
| 123 | NbN | 5 |
| 122 | $Si_3N_4$:Al | 17 |

Cet exemple 4 est ainsi sensiblement identique à l'exemple 1 sauf en ce que les couches diélectriques 122 et 166 ont été séparées chacune en deux parties d'épaisseur sensiblement identique (respectivement 122 / 124 et 164 / 166) et en ce qu'une couche absorbante 123, 165 a été insérée à chaque fois entre ces deux couches, c'est-à-dire sensiblement au milieu des couches 122 et 166 de l'exemple 1.

Par ailleurs, la matière absorbante des couches absorbante est disposée majoritairement (à plus de 80 %) dans le revêtement sous-jacent 120, c'est-à-dire entre le substrat porteur et la couche fonctionnelle 140.

Le tableau 8 ci-après résume les principales caractéristiques optiques et énergétique de cet exemple 4, respectivement lorsque l'on considère uniquement le substrat seul, sans traitement thermique, et lorsque celui-ci est monté en double vitrage, en face 2, comme en figure 2 et en face 3, comme en figure 3.

Tableau 8

| | R | | $T_L$ | $a_T^*$ | $b_T^*$ | $R_c$ | $a_c^*$ | $b_c^*$ | $R_g$ | $a_g^*$ | $b_g^*$ |
|----|------|------|-------|---------|---------|-------|---------|---------|-------|---------|---------|
| 10 | 3,7 | | 53,3 | -4,5 | 1,4 | 6,5 | 19,4 | -21,7 | 4,8 | 1,8 | -2,6 |
| | FS | S | $T_L$ | $a_T^*$ | $b_T^*$ | $R_e$ | $a_e^*$ | $b_e^*$ | $R_i$ | $a_i^*$ | $b_i^*$ |
| F2 | 37,8 | 1,27 | 48,1 | -5,2 | 1,2 | 7,1 | -0,3 | -1,7 | 13,4 | 9,4 | -12,7 |
| F3 | 57,2 | 0,84 | 48,1 | -5,2 | 1,2 | 13,4 | 9,4 | -12,7 | 7,1 | -0,3 | -1,7 |

Comme visible dans ce tableau 8, la réflexion lumineuse extérieure $R_e$ est très satisfaisante lorsque l'empilement est positionné en face 2 : elle est de l'ordre de 7 % ; elle est moins satisfaisante lorsque l'empilement est positionné en face 3.

Par ailleurs, la couleur vue de l'extérieur, est peu différente de celle de l'exemple 1 et reste neutre, que l'empilement ait subi ou non un traitement thermique.

L'épaisseur totale e de couche absorbante 123 dans l'empilement en nanomètres est telle que, en application de la formule $e = a \times e_{40} + 55 - FS$, en double-vitrage face 2 : a = - 0,9.

Le tableau 9 ci-après illustre les épaisseurs géométriques en nanomètres de chacune des couches de l'exemple 5 :

Tableau 9

| Couche | Matériau | Ex. 5 |
|---|---|---|
| 166 | $Si_3N_4{:}Al$ | 12 |
| 165 | NbN | 5 |
| 164 | $Si_3N_4{:}Al$ | 18 |
| 162 | ZnO:Al | 9 |
| 150 | NiCr | 1 |
| 140 | Ag | 12 |
| 128 | ZnO:Al | 10 |
| 126 | $SnZnO_x{:}Sb$ | 5 |
| 124 | $Si_3N_4{:}Al$ | 15 |
| 123 | NbN | 1 |
| 122 | $Si_3N_4{:}Al$ | 17 |

Cet exemple 5 présente une structure identique à celle de l'exemple 4.

Toutefois, à la différence de l'exemple 4, la matière absorbante des couches absorbante est disposée majoritairement (à plus de 80 %) dans le revêtement sus-jacent 160, c'est-à-dire au-dessus de la couche fonctionnelle 140, à l'opposé du substrat porteur.

Le tableau 10 ci-après résume les principales caractéristiques optiques et énergétique de cet exemple 5, respectivement lorsque l'on considère uniquement le substrat seul, sans traitement thermique, et lorsque celui-ci est monté en double vitrage, en face 2, comme en figure 2 et en face 3, comme en figure 3.

Tableau 10

|  | R | | $T_L$ | $a_T{}^*$ | $b_T{}^*$ | $R_c$ | $a_c{}^*$ | $b_c{}^*$ | $R_g$ | $a_g{}^*$ | $b_g{}^*$ |
|---|---|---|---|---|---|---|---|---|---|---|---|
| 10 | 3,7 | | 48,7 | -3,4 | -1,2 | 2,2 | 15 | -19,9 | 12,2 | 5,8 | -5,9 |
|  | FS | s | $T_L$ | $a_T{}^*$ | $b_T{}^*$ | $R_e$ | $a_e{}^*$ | $b_e{}^*$ | $R_i$ | $a_i{}^*$ | $b_i{}^*$ |
| F2 | 35,4 | 1,23 | 43,7 | -4,2 | -1,1 | 14,1 | 4,5 | -5,6 | 9,9 | 4,1 | -7,9 |
| F3 | 57,2 | 0,76 | 43,7 | -4,2 | -1,1 | 9,9 | 4,1 | -7,9 | 14,1 | 4,5 | -5,6 |

Comme visible dans ce tableau 10, la réflexion lumineuse extérieure $R_e$ est très satisfaisante lorsque l'empilement est positionné en face 3 : elle est de l'ordre de 10 % ; elle est moins satisfaisante lorsque l'empilement est positionné en face 2.

Par ailleurs, la couleur vue de l'extérieur, est peu différente de celle de l'exemple 1 et reste neutre, que l'empilement ait subi ou non un traitement thermique.

L'épaisseur totale e des couches absorbantes 123 et 165 dans l'empilement de couche minces positionné sur la face intérieure du substrat 10 (le premier substrat traversé par le rayonnement solaire incident) en nanomètres est telle que, en application de la formule $e = a \times e_{40} + 55 - FS$, en double-vitrage face 2 : a = - 1,1.

Ainsi, selon l'invention, lorsque l'empilement de couche minces est positionné en face 2 du vitrage multiple, l'épaisseur totale e de couche absorbante 123 et/ou 165 dans l'empilement en nanomètres est : $e = a \times e_{40} + 55 - FS$, avec :

$$0,5 \text{ nm} < e < 10 \text{ nm}$$

$$-1,5 < a < 0$$

$$5 \ nm \leq e_{40} \leq 20 \ nm$$

et

FS, le facteur solaire en %.

Cette formule résume ainsi l'épaisseur totale de couche absorbante nécessaire dans le cadre de la mise en oeuvre de l'invention.

Par ailleurs, d'une manière générale, le traitement thermique de trempe n'a que peu affecté les exemples selon l'invention.

En particulier, la résistance par carré des empilements selon l'invention, tant avant qu'après traitement thermique est toujours inférieure à 4 ohms par carré.

Les exemples 2 à 5 montrent qu'il est possible de combiner une forte sélectivité, une faible émissivité et une faible réflexion lumineuse extérieure, avec un empilement comportant une seule couche métallique fonctionnelle en argent, tout en conservant une esthétique convenable (la $T_L$ est supérieure à 60 % et les couleurs sont neutres en réflexion).

De plus, la réflexion lumineuse $R_L$, la transmission lumineuse $T_L$ mesurées selon l'illuminant D65 et les couleurs en réflexion a* et b* dans le système LAB mesurées selon l'illuminant D65 côté substrat ne varient pas de manière vraiment significative lors du traitement thermique.

En comparant les caractéristiques optiques et énergétiques avant traitement thermique avec ces mêmes caractéristiques après traitement thermique, aucune dégradation majeure n'a été constatée.

En outre, la résistance mécanique de l'empilement selon l'invention est très bonne. Par ailleurs, la tenue chimique générale de cet empilement est globalement bonne.

Lorsqu'un empilement monocouche fonctionnelle est utilisé dans un vitrage multiple 100 de structure triple vitrage, ce vitrage comporte trois substrats 10, 20, 30 qui sont maintenus ensemble par une structure de châssis 90 et qui sont séparés, respectivement deux par deux, par une lame de gaz intercalaire 15, 25. Le vitrage réalise ainsi une séparation entre un espace extérieur ES et un espace intérieur IS.

L'empilement peut être positionné en face 2 (sur la feuille de verre la plus à l'extérieur du bâtiment en considérant le sens incident de la lumière solaire entrant dans le bâtiment et sur sa face tournée vers la lame de gaz) ou en face 5 (sur la feuille la plus à l'intérieur du bâtiment en considérant le sens incident de la lumière solaire entrant dans le bâtiment et sur sa face tournée vers la lame de gaz).

Les figures 5 et 6 illustrent respectivement le positionnement :

- en face 2 d'un empilement de couches minces 14 positionné sur une face intérieure 11 du substrat 10 en contact avec la lame de gaz intercalaire 15, l'autre face 9 du substrat 10 étant en contact avec l'espace extérieur ES ; et
- en face 5 d'un empilement de couches minces 26 positionné sur une face intérieure 29 du substrat 30 en contact avec la lame de gaz intercalaire 25, l'autre face 31 du substrat 30 étant en contact avec l'espace intérieur IS.

Toutefois, il peut aussi être envisagé que dans cette structure de triple vitrage, l'un des substrats présente une structure feuilletée ; toutefois, il n'y a pas de confusion possible car dans une telle structure, il n'y a pas de lame de gaz intercalaire.

Il peut en outre être prévu qu'au moins un substrat 10, 20, 30 comporte sur au moins une face 11, 19, 21, 29 en contact avec une lame de gaz intercalaire 15, 25 un revêtement antireflet 18, 22 qui est en vis-à-vis par rapport à ladite lame de gaz intercalaire 15, 25 avec un empilement de couches minces 14, 26 à propriétés de réflexion dans l'infrarouge et/ou dans le rayonnement solaire.

La figure 6 illustre ainsi le cas où le substrat 20 central du triple vitrage comporte sur sa face 21 qui est en contact avec la lame de gaz intercalaire 25 un revêtement antireflet 22 qui est en vis-à-vis par rapport à ladite lame de gaz intercalaire 25 avec l'empilement de couches minces 26 à propriétés de réflexion dans l'infrarouge et/ou dans le rayonnement solaire.

Bien évidement, si dans le cadre de la mise en oeuvre de l'invention, l'empilement de couches minces 14 à propriétés de réflexion dans l'infrarouge et/ou dans le rayonnement solaire est positionné sur la face 11 du substrat 10, c'est alors la face 19 du substrat 20 central du triple vitrage qui est en contact avec la lame de gaz intercalaire 15 qui comporte un revêtement antireflet 18 qui est en vis-à-vis par rapport à ladite lame de gaz intercalaire 15 avec l'empilement de couches minces 14.

Dans ces deux cas, il peut aussi être prévu que l'autre face du substrat 20 central du triple vitrage soit aussi pourvue d'un revêtement antireflet, comme illustré pour le premier de ces deux cas en figure 6.

Le but de cette insertion d'un (ou de plusieurs) revêtement(s) antireflet(s) dans une structure de triple vitrage est de permettre d'obtenir une transmission lumineuse élevée et un facteur solaire élevé, tout au moins une transmission lumineuse et un facteur solaire similaires à ceux d'un double vitrage à isolation thermique renforcée.

La présente invention est décrite dans ce qui précède à titre d'exemple. Il est entendu que l'homme du métier est à même de réaliser différentes variantes de l'invention sans pour autant sortir du cadre du brevet tel que défini par les revendications.

## Revendications

1. Vitrage multiple (100) comportant au moins deux substrats (10, 30) qui sont maintenus ensemble par une structure de châssis (90), ledit vitrage réalisant une séparation entre un espace extérieur (ES) et un espace intérieur (IS), dans lequel au moins une lame de gaz intercalaire (15) est disposée entre les deux substrats, un substrat (10, 30) étant revêtu sur une face intérieure (11, 29) en contact avec la lame de gaz intercalaire (15) d'un empilement de couches minces (14, 26) à propriétés de réflexion dans l'infrarouge et/ou dans le rayonnement solaire comportant une seule couche fonctionnelle métallique (140), en particulier à base d'argent ou d'alliage métallique contenant de l'argent et deux revêtements diélectriques (120, 160), lesdits revêtements comportant chacun au moins une couche diélectrique (122, 126 ; 162, 166), ladite couche fonctionnelle (140) étant disposée entre les deux revêtements diélectriques (120, 160), *caractérisé en ce que* les deux revêtements diélectriques (120, 160), comportent une couche absorbante (123, 165) qui est disposée dans le revêtement diélectrique entre deux couches diélectriques (122, 126 ; 162, 166), la matière absorbante des couches absorbantes (123, 165) étant majoritairement dans le revêtement diélectrique (120) sous-jacent à la couche fonctionnelle métallique (140) ou majoritairement dans le revêtement diélectrique (160) sus-jacent à la couche fonctionnelle métallique (140) avec plus de la moitié de l'épaisseur totale de la matière absorbante des couches absorbantes de l'empilement qui est située soit dans le revêtement diélectrique sous-jacent à la couche fonctionnelle métallique, soit dans le revêtement diélectrique sus-jacent à la couche fonctionnelle métallique, de telle sorte que :

   - soit la matière absorbante de toutes les couches absorbantes (123, 165) est majoritairement dans le revêtement diélectrique (120) sous-jacent à la couche fonctionnelle métallique (140) et l'empilement de couches minces (14) est positionné sur la face intérieure (11) du substrat (10) en contact sur une autre face (9) avec l'espace extérieur (ES) ;
   - soit la matière absorbante de toutes les couches absorbantes (123, 165) est majoritairement dans le revêtement diélectrique (160) sus-jacent à la couche fonctionnelle métallique (140) et l'empilement de couches minces (26) est positionné sur la face intérieure (29) du substrat (30) en contact sur une autre face (31) avec l'espace intérieur (IS).

2. Vitrage multiple (100) comportant au moins trois substrats (10, 20, 30) qui sont maintenus ensemble par une structure de châssis (90), ledit vitrage réalisant une séparation entre un espace extérieur (ES) et un espace intérieur (IS), dans lequel au moins deux lame de gaz intercalaire (15, 25) sont disposées chacune entre deux substrats, un substrat (10, 30) étant revêtu sur une face intérieure (11, 29) en contact avec la lame de gaz intercalaire (15, 25) d'un empilement de couches minces (14, 26) à propriétés de réflexion dans l'infrarouge et/ou dans le rayonnement solaire comportant une seule couche fonctionnelle métallique (140), en particulier à base d'argent ou d'alliage métallique contenant de l'argent et deux revêtements diélectriques (120, 160), lesdits revêtements comportant chacun au moins une couche diélectrique (122, 126; 162, 166), ladite couche fonctionnelle (140) étant disposée entre les deux revêtements diélectriques (120, 160), *caractérisé en ce que* les deux revêtements diélectriques (120, 160), comportent une couche absorbante (123, 165) qui est disposée dans le revêtement diélectrique entre deux couches diélectriques (122, 126 ; 162, 166), la matière absorbante des couches absorbantes (123, 165) étant majoritairement dans le revêtement diélectrique (120) sous-jacent à la couche fonctionnelle métallique (140) ou majoritairement dans le revêtement diélectrique (160) sus-jacent à la couche fonctionnelle métallique (140) avec plus de la moitié de l'épaisseur totale de la matière absorbante des couches absorbantes de l'empilement qui est située soit dans le revêtement diélectrique sous-jacent à la couche fonctionnelle métallique, soit dans le revêtement diélectrique sus-jacent à la couche fonctionnelle métallique, de telle sorte que :

   - soit la matière absorbante de toutes les couches absorbantes (123, 165) est majoritairement dans le revêtement diélectrique (120) sous-jacent à la couche fonctionnelle métallique (140) et l'empilement de couches minces (14) est positionné sur la face intérieure (11) du substrat (10) en contact sur une autre face (9) avec l'espace extérieur (ES) ;
   - soit la matière absorbante de toutes les couches absorbantes (123, 165) est majoritairement dans le revêtement diélectrique (160) sus-jacent à la couche fonctionnelle métallique (140) et l'empilement de couches minces (26) est positionné sur la face intérieure (29) du substrat (30) en contact sur une autre face (31) avec l'espace intérieur (IS).

**3.** Vitrage multiple (100) selon la revendication 1 ou la revendication 2, *caractérisé en ce qu'*au moins un substrat (10, 20, 30) comporte sur au moins une face (11, 19, 21, 29) en contact avec une lame de gaz intercalaire (15, 25) un revêtement antireflet (18, 22) qui est en vis-à-vis par rapport à ladite lame de gaz intercalaire (15, 25) avec un empilement de couches minces (14, 26) à propriétés de réflexion dans l'infrarouge et/ou dans le rayonnement solaire.

**4.** Vitrage multiple (100) selon l'une quelconque des revendications 1 à 3, *caractérisé en ce que* l'épaisseur totale e de couche absorbante (123, 165) en nanomètres de l'empilement de couches minces (14) positionné sur la face intérieure (11) du substrat (10), est telle que : $e = a \times e_{140} + 55 - FS$ avec :

$$0,5 \ nm < e < 10 \ nm$$

$$-1,5 < a < 0$$

épaisseur physique de la couche fonctionnelle métallique (140) : $5 \ nm \leq e_{140} \leq 20 \ nm$ et
FS, le facteur solaire du vitrage multiple en %.

**5.** Vitrage multiple (100) selon l'une quelconque des revendications 1 à 4, *caractérisé en ce que* au moins une couche absorbante (123, 165), et de préférence toutes les couches absorbantes, est ou sont à base de nitrure et en particulier à base de nitrure de niobium NbN ou à base de nitrure de titane TiN.

**6.** Vitrage multiple (100) selon l'une quelconque des revendications 1 à 5, *caractérisé en ce que* ladite (ou chaque) couche absorbante (123, 165) présente une épaisseur comprise entre 0,5 et 10 nm, en incluant ces valeurs, voire entre 2 et 8 nm, en incluant ces valeurs.

**7.** Vitrage multiple (100) selon l'une quelconque des revendications 1 à 6, *caractérisé en ce que* lesdits revêtements diélectrique sous-jacent (120) et diélectrique sus-jacent (160) comportent chacun au moins une couche diélectrique (122, 166) à base de nitrure de silicium, éventuellement dopé à l'aide d'au moins un autre élément, comme l'aluminium.

**8.** Vitrage multiple (100) selon l'une quelconque des revendications 1 à 7, *caractérisé en ce que* chaque couche absorbante (123, 165) est disposée dans le revêtement diélectrique entre deux couches diélectrique (122, 124 ; 164, 166) qui sont toutes les deux à base de nitrure de silicium, éventuellement dopé à l'aide d'au moins un autre élément, comme l'aluminium.

**9.** Vitrage multiple (100) selon l'une quelconque des revendications 1 à 8, *caractérisé en ce que* la couche fonctionnelle (140) est déposée directement sur un revêtement de sous-blocage (130) disposé entre la couche fonctionnelle (140) et le revêtement diélectrique (120) sous-jacent à la couche fonctionnelle et/ou la couche fonctionnelle (140) est déposée directement sous un revêtement de sur-blocage (150) disposé entre la couche fonctionnelle (140) et le revêtement diélectrique (160) sus-jacent à la couche fonctionnelle *et en ce que* le revêtement de sous-blocage (130) et/ou le revêtement de sur-blocage (150) comprend une couche fine à base de nickel ou de titane présentant une épaisseur physique e' telle que $0,2 \ nm \leq e' \leq 2,5 \ nm$.

**10.** Vitrage multiple (100) selon l'une quelconque des revendications 1 à 9, *caractérisé en ce que* la dernière couche (168) du revêtement diélectrique sus-jacent (160), celle la plus éloignée du substrat, est à base d'oxyde, déposée de préférence sous stoechiométrique, et notamment est à base de titane ($TiO_x$) ou à base d'oxyde mixte de zinc et d'étain ($SnZnO_x$).

**11.** Utilisation d'un empilement de couches minces (14, 26) à propriétés de réflexion dans l'infrarouge et/ou dans le rayonnement solaire comportant une seule couche fonctionnelle métallique (140), en particulier à base d'argent ou d'alliage métallique contenant de l'argent et deux revêtements diélectriques (120, 160), lesdits revêtements comportant chacun au moins une couche diélectrique (122, 126 ; 164, 168), ladite couche fonctionnelle (140) étant disposée entre les deux revêtements diélectriques (120, 160) et ledit empilement de couches minces (14, 26) étant disposé sur une face intérieure (11, 29) d'au moins un substrat (10, 30) pour réaliser un vitrage multiple (100) selon l'une quelconque des revendications 1 à 10 comportant au moins deux substrats (10, 30), qui sont maintenus ensemble par une structure de châssis (90) et dans lequel une lame de gaz intercalaire (15) est disposée deux substrats.

**12.** Procédé de fabrication d'un vitrage multiple (100) selon l'une quelconque des revendications 1 à 10 comportant au moins deux substrats (10, 30) qui sont maintenus ensemble par une structure de châssis (90), ledit vitrage réalisant une séparation entre un espace extérieur (ES) et un espace intérieur (IS), dans lequel au moins une lame de gaz intercalaire (15) est disposée entre les deux substrats, un substrat (10, 20) étant revêtu sur une face intérieure (11, 29) en contact avec la lame de gaz intercalaire (15) d'un empilement de couches minces (14, 26) à propriétés de réflexion dans l'infrarouge et/ou dans le rayonnement solaire comportant une seule couche fonctionnelle métallique (140), en particulier à base d'argent ou d'alliage métallique contenant de l'argent et deux revêtements diélectriques (120, 160), lesdits revêtements comportant chacun au moins une couche diélectrique (122, 126 ; 164, 168), ladite couche fonctionnelle (140) étant disposée entre les deux revêtements diélectriques (120, 160), *caractérisé en ce que* les deux revêtements diélectriques (120, 160), comportent une couche absorbante (123, 165) qui est disposée dans le revêtement diélectrique entre deux couches diélectriques (122, 126 ; 162, 166), la matière absorbante des couches absorbantes (123, 165) étant majoritairement dans le revêtement diélectrique (120) sous-jacent à la couche fonctionnelle métallique (140) ou majoritairement dans le revêtement diélectrique (160) sus-jacent à la couche fonctionnelle métallique (140) avec plus de la moitié de l'épaisseur totale de la matière absorbante des couches absorbantes de l'empilement qui est située soit dans le revêtement diélectrique sous-jacent à la couche fonctionnelle métallique, soit dans le revêtement diélectrique sus-jacent à la couche fonctionnelle métallique, de telle sorte que :

- soit le substrat (10) est positionné dans la structure de châssis (90) pour que sa face intérieure (11) comporte un empilement de couches minces (14) dont la matière absorbante de toutes les couches absorbantes (123, 165) est majoritairement dans le revêtement diélectrique (120) sous-jacent à la couche fonctionnelle métallique (140) et que son autre face (9) soit en contact avec l'espace extérieur (ES) ;
- soit le substrat (30) est positionné dans la structure de châssis (90) pour que sa face intérieure (29) comporte un empilement de couches minces (26) dont la matière absorbante de toutes les couches absorbantes (123, 165) est majoritairement dans le revêtement diélectrique (160) sus-jacent à la couche fonctionnelle métallique (140) et que son autre face (31) soit en contact avec l'espace intérieur (IS).

**Patentansprüche**

**1.** Mehrfachverglasung (100), aufweisend mindestens zwei Substrate (10, 30), die durch eine Gestellstruktur (90) zusammengehalten werden, wobei die besagte Verglasung eine Trennung zwischen einem Außenbereich (ES) und einem Innenbereich (IS) bildet, wobei mindestens eine Gaszwischenfeder (15) zwischen den beiden Substraten angeordnet ist, wobei ein Substrat (10, 30) auf einer Innenseite (11, 29) im Kontakt mit der Gaszwischenfeder (15) mit einem Stapel dünner Schichten (14, 26) mit Reflexionseigenschaften im Infrarot und/oder bei Sonnenstrahlung beschichtet ist, aufweisend eine einzige funktionelle metallische Schicht (140), insbesondere auf der Basis von Silber oder einer Metalllegierung, die Silber enthält, und zwei dielektrische Beschichtungen (120, 160), wobei die besagten Beschichtungen jeweils mindestens eine dielektrische Schicht (122, 126; 162, 166) aufweisen, wobei die besagte funktionelle Schicht (140) zwischen den beiden dielektrischen Beschichtungen (120, 160) angeordnet ist, **dadurch gekennzeichnet, dass** die beiden dielektrischen Beschichtungen (120, 160) eine absorbierende Schicht (123, 165) umfassen, die in der dielektrischen Beschichtung zwischen zwei dielektrischen Schichten (122, 126; 162, 166) angeordnet ist, wobei das absorbierende Material der absorbierenden Schichten (123, 165) hauptsächlich in der dielektrischen Beschichtung (120) unter der funktionellen metallischen Schicht (140) oder hauptsächlich in der dielektrischen Beschichtung (160) über der funktionellen metallischen Schicht (140) ist mit über der Hälfte der Gesamtdicke des absorbierenden Materials der absorbierenden Schichten des Stapels, die sich entweder in der dielektrischen Beschichtung unter der funktionellen metallischen Schicht oder in der dielektrischen Beschichtung über der funktionellen metallischen Schicht befindet, sodass:

- entweder das absorbierende Material aller absorbierenden Schichten (123, 165) hauptsächlich in der dieletrischen Beschichtung (120) unter der funktionellen metallischen Schicht (140) ist und der Stapel dünner Schichten (14) auf der Innenseite (11) des Substrats (10) im Kontakt auf einer anderen Seite (9) mit dem Außenbereich (ES) angeordnet ist;
- oder das absorbierende Material aller absorbierenden Schichten (123, 165) hauptsächlich in der dieletrischen Beschichtung (160) über der funktionellen metallischen Schicht (140) ist und der Stapel dünner Schichten(26) auf der Innenseite (29) des Substrats (30) im Kontakt auf einer anderen Seite (31) mit dem Innenbereich (IS) angeordnet ist.

**2.** Mehrfachverglasung (100), aufweisend mindestens drei Substrate (10, 20, 30), die durch eine Gestellstruktur (90) zusammengehalten werden, wobei die besagte Verglasung eine Trennung zwischen einem Außenbereich (ES) und einem Innenbereich (IS) bildet, wobei mindestens zwei Gaszwischenfedern (15, 25) zwischen zwei Substraten angeordnet sind, wobei ein Substrat (10, 30) auf einer Innenseite (11, 29) im Kontakt mit der Gaszwischenfeder (15, 25) mit einem Stapel dünner Schichten (14, 26) mit Reflexionseigenschaften im Infrarot und/oder bei Sonnenstrahlung beschichtet ist, aufweisend eine einzige funktionelle metallische Schicht (140), insbesondere auf der Basis von Silber oder einer Metalllegierung, die Silber enthält, und zwei dielektrische Beschichtungen (120, 160), wobei die besagten Beschichtungen jeweils mindestens eine dielektrische Schicht (122, 126; 162, 166) aufweisen, wobei die besagte funktionelle Schicht (140) zwischen den beiden dielektrischen Beschichtungen (120, 160) angeordnet ist, **dadurch gekennzeichnet, dass** die beiden dielektrischen Beschichtungen (120, 160) eine absorbierende Schicht (123, 165) aufweisen, die in der dielektrischen Beschichtung zwischen zwei dielektrischen Schichten (122, 126; 162, 166) angeordnet ist, wobei das absorbierende Material der absorbierenden Schichten (123) hauptsächlich in der dielektrischen Beschichtung (120) unter der funktionellen metallischen Schicht (140) oder hauptsächlich in der dielektrischen Beschichtung (160) über der funktionellen metallischen Schicht (140) ist mit über der Hälfte der Gesamtdicke des absorbierenden Materials der absorbierenden Schichten des Stapels, die sich entweder in der dielektrischen Beschichtung unter der funktionellen metallischen Schicht oder in der dielektrischen Beschichtung über der funktionellen metallischen Schicht befindet, sodass:

- entweder das absorbierende Material aller absorbierenden Schichten (123, 165) hauptsächlich in der dieletrischen Beschichtung (120) unter der funktionellen metallischen Schicht (140) ist und der Stapel dünner Schichten (14) auf der Innenseite (11) des Substrats (10) im Kontakt auf einer anderen Seite (9) mit dem Außenbereich (ES) angeordnet ist;
- oder das absorbierende Material aller absorbierenden Schichten (123, 165) hauptsächlich in der dieletrischen Beschichtung (160) über der funktionellen metallischen Schicht (140) ist und der Stapel dünner Schichten(26) auf der Innenseite (29) des Substrats (30) im Kontakt auf einer anderen Seite (31) mit dem Innenbereich (IS) angeordnet ist.

3. Mehrfachverglasung (100) nach Anspruch 1 oder Anspruch 2, **dadurch gekennzeichnet, dass** mindestens ein Substrat (10, 20, 30) auf mindestens einer Seite (11, 19, 21, 29) im Kontakt mit einer Gaszwischenfeder (15, 25) eine Antireflexbeschichtung (18, 22) aufweist, die sich in Bezug auf die besagte Gaszwischenfeder (15, 25) mit einem Stapel dünner Schichten (14, 26) mit Reflexionseigenschaften im Infrarot und/oder bei Sonnenbestrahlung gegenüber befindet.

4. Mehrfachverglasung (100) nach einem der Ansprüche 1 bis 3, **dadurch gekennzeichnet, dass** die Gesamtdicke e der absorbierenden Schicht (123, 165) in Nanometern des Stapels dünner Schichten (14), positioniert auf der Innenseite (11) des Substrats (10), derart ist, dass $e = a \times e_{140} + 55 - FS$ mit:

$$0{,}5 \text{ nm} < e < 10 \text{ nm}$$

$$-1{,}5 < a < 0$$

physische Dicke der funktionellen metallischen Schicht (140): $5 \text{ nm} \leq e_{140} \leq 20 \text{ nm}$ und FS, dem Sonnenfaktor der Mehrfachverglasung in %.

5. Mehrfachverglasung (100) nach einem der Ansprüche 1 bis 4, **dadurch gekennzeichnet, dass** mindestens eine absorbierende Schicht (123, 165) und vorzugsweise alle absorbierenden Schichten auf Nitridbasis und insbesondere auf Niobiumnitridbasis NbN oder Titannidridbasis TiN ist oder sind.

6. Mehrfachverglasung (100) nach einem der Ansprüche 1 bis 5, **dadurch gekennzeichnet, dass** die besagte (oder jede) absorbierende Schicht (123, 165) eine Dicke zwischen 0,5 und 10 nm aufweist, diese Werte eingeschlossen, bzw. zwischen 2 und 8 nm, diese Werte eingeschlossen.

7. Mehrfachverglasung (100) nach einem der Ansprüche 1 bis 6, **dadurch gekennzeichnet, dass** die besagte darunterliegende (120) und darüberliegende (160) dielektrische Beschichtung jeweils mindestens eine dielektrische Schicht (122, 166) auf Siliziumnitridbasis aufweisen, möglicherweise dotiert mit Hilfe mindestens eines weiteren Elements wie Aluminium.

8. Mehrfachverglasung (100) nach einem der Ansprüche 1 bis **7, dadurch gekennzeichnet, dass** jede absorbierende Schicht(123, 165) in der dielektrischen Beschichtung zwischen zwei dielektrischen Schichten (122, 124; 164, 166) angeordnet ist, die beide auf der Basis von Siliziumnitrid sind, möglicherweise dotiert mit Hilfe mindestens eines weiteren Elements wie Aluminium.

9. Mehrfachverglasung (100) nach einem der Ansprüche 1 bis **8, *dadurch gekennzeichnet, dass*** die funktionelle Schicht (140) direkt auf einer Unterblock-Beschichtung (130) aufgebracht ist, die zwischen der funktionellen Schicht (140) und der dielektrischen Beschichtung (120) unter der funktionellen Schicht angeordnet ist und/oder die funktionellen Schicht (140) direkt unter einer Überblock-Beschichtung (150) aufgebracht ist, die zwischen der funktionellen Schicht (140) und der dielektrischen Beschichtung (160) über der funktionellen Schicht angeordnet ist, und dadurch, dass die Unterblock-Beschichtung (130) und/oder die Überblock-Beschichtung (150) eine dünne Schicht auf der Basis von Nickel oder Titan umfasst, die eine physische Dicke e' derart aufweist, dass $0,2\,nm \leq e' \leq 2,5\,nm$ ist.

10. Mehrfachverglasung (100) nach einem der Ansprüche 1 bis 9, ***dadurch gekennzeichnet, dass*** die letzte Schicht (168) der darüberliegenden dielektrischen Beschichtung (160), die am weitesten von dem Substrat entfernt ist, auf Oxidbasis ist, aufgebracht vorzugsweise unterstöchiometrisch, und insbesondere auf Titanbasis ($TiO_x$) oder auf Mischoxidbasis aus Zink und Zinn ($SnZnO_x$) ist.

11. Verwendung eines Stapels dünner Schichten (14, 26) mit Reflexionseigenschaften im Infrarot und/oder bei Sonnenstrahlung, aufweisend eine einzige funktionelle metallische Schicht (140), insbesondere auf der Basis von Silber oder einer Metalllegierung, die Silber enthält, und zwei dielektrische Beschichtungen (120, 160), wobei die besagten Beschichtungen jeweils mindestens eine dielektrische Schicht (122, 126; 164, 168) aufweisen, wobei die besagte funktionelle Schicht (140) zwischen den beiden dielektrischen Beschichtungen (120, 160) angeordnet ist und der besagte Stapel dünner Schichten (14, 26) auf einer Innenseite (11, 29) mindestens eines Substrats (10, 30) aufgebracht ist, um eine Mehrfachverglasung (100) nach einem der Ansprüche 1 bis 10 zu bilden, aufweisend mindestens zwei Substrate (10, 30), die durch eine Gestellstruktur (90) zusammengehalten werden und wobei eine Gaszwischenfeder (15) zwischen zwei Substraten angeordnet ist.

12. Verfahren zur Herstellung einer Mehrfachverglasung (100) nach einem der Ansprüche 1 bis 10, aufweisend mindestens zwei Substrate (10, 30), die durch eine Gestellstruktur (90) zusammengehalten werden, wobei die besagte Verglasung eine Trennung zwischen einem Außenbereich (ES) und einem Innenbereich(IS) bildet, wobei mindestens eine Gaszwischenfeder (15) zwischen den beiden Substraten angeordnet ist, wobei ein Substrat (10, 20) auf einer Innenseite(11, 29) im Kontakt mit der Gaszwischenfeder (15) eines Stapels dünner Schichten (14, 26) mit Reflexionseigenschaften im Infrarot und/oder bei Sonnenstrahlung beschichtet ist, aufweisend eine einzige funktionelle metallische Schicht (140), insbesondere auf der Basis von Silber oder einer Metalllegierung, die Silber enthält, und zwei dielektrische Beschichtungen (120, 160),wobei die besagten Beschichtungen jeweils mindestens eine dielektrische Schicht(122, 126; 164, 168) aufweisen, wobei die besagte funktionelle Schicht (140) zwischen den beiden dielektrischen Beschichtungen (120, 160) angeordnet ist, **dadurch gekennzeichnet, dass** die beiden dielektrischen Beschichtungen (120, 160) eine absorbierende Schicht (123, 165) umfassen, die in der dielektrischen Beschichtung zwischen zwei dielektrischen Schichten (122, 126; 162, 166) angeordnet ist, wobei das absorbierende Material der absorbierenden Schichten (123, 165) hauptsächlich in der dielektrischen Beschichtung (120) unter der funktionellen metallischen Schicht (140) oder hauptsächlich in der dielektrischen Beschichtung (160) über der funktionellen metallischen Schicht (140) ist mit mehr als der Hälfte der Gesamtdicke des absorbierenden Materials der absorbierenden Schichten des Stapels, die sich entweder in der dielektrischen Beschichtung unter der funktionellen metallischen Schicht oder in der dielektrischen Beschichtung über der funktionellen metallischen Schicht befindet, sodass:

   - das Substrat (10) entweder in der Gestellstruktur (90) angeordnet ist, damit dessen Innenseite (11) einen Stapel dünner Schichten (14) aufweist, wobei sich das absorbierende Material aller absorbierender Schichten (123, 165) hauptsächlich in der dielektrischen Beschichtung (120) unter der funktionellen metallischen Schicht (140) befindet und seine andere Seite (9) im Kontakt mit dem Außenbereich (ES) ist;
   - oder das Substrat (30) in der Gestellstruktur (90) angeordnet ist, damit dessen Innenseite (29) einen Stapel dünner Schichten (26) aufweist, wobei sich das absorbierende Material aller absorbierender Schichten (123, 165) hauptsächlich in der dielektrischen Beschichtung (160) über der funktionellen metallischen Schicht (140) befindet und seine andere Seite (31) im Kontakt mit dem Innenbereich (IS) ist.

**Claims**

1. A multiple glazing (100) comprising at least two substrates (10, 30) which are held together by a frame structure (90), said glazing providing a separation between an external space (ES) and an internal space (IS), in which at least one gas-filled cavity (15) lies between the two substrates, one substrate (10, 30) being coated on an inner face (11, 29) in contact with the gas-filled cavity (15) with a thin-film multilayer coating (14, 26) having reflection properties in the infrared and/or in solar radiation, said coating comprising a single metallic functional layer (140), in particular based on silver or a metal alloy containing silver, and two dielectric films (120, 160), said films each comprising at least one dielectric layer (122, 126; 162, 166), said functional layer (140) being placed between the two dielectric films (120, 160), *characterized in that* both dielectric films (120, 160) include an absorbent layer (123, 165) which is placed in the dielectric film between two dielectric layers (122, 126; 162, 166), the absorbent material of the absorbent layers (123, 165) being predominantly in the dielectric film (120) subjacent to the metallic functional layer (140) or predominantly in the dielectric film (160) superjacent to the metallic functional layer (140) with more than half of the total thickness of the absorbent material of the absorbent layers of the multilayer coating is located either in the dielectric film subjacent to the metallic functional layer or in the dielectric film superjacent to the metallic functional layer, in such a way that:

- either the absorbent material of all the absorbent layers (123, 165) is predominantly in the dielectric film (120) subjacent to the metallic functional layer (140), and the thin-film multilayer coating (14) is positioned on the inner face (11) of the substrate (10) in contact on another face (9) with the external space (ES);
- or the absorbent material of all the absorbent layers (123, 165) is predominantly in the dielectric film (160) superjacent to the metallic functional layer (140), and the thin-film multilayer coating (26) is positioned on the inner face (29) of the substrate (30) in contact on another face (31) with the internal space (IS).

2. A multiple glazing (100) comprising at least three substrates (10, 20, 30) that are held together by a frame structure (90), said glazing providing a separation between an external space (ES) and an internal space (IS), in which at least two gas-filled cavities (15, 25) each lie between two substrates, one substrate (10, 30) being coated on an inner face (11, 29) in contact with the gas-filled cavity (15, 25) with a thin-film multilayer coating (14, 26) having reflection properties in the infrared and/or in solar radiation, said coating comprising a single metallic functional layer (140), in particular based on silver or a metal alloy containing silver, and two dielectric films (120, 160), said films each comprising at least one dielectric layer (122, 126; 162, 166), said functional layer (140) being placed between the two dielectric films (120, 160), *characterized in that* both dielectric films (120, 160) include an absorbent layer (123, 165) which is placed in the dielectric film between two dielectric layers (122, 126; 162, 166), the absorbent material of the absorbent layers (123, 165) being predominantly in the dielectric film (120) subjacent to the metallic functional layer (140) or predominantly in the dielectric film (160) superjacent to the metallic functional layer (140) with more than half of the total thickness of the absorbent material of the absorbent layers of the multilayer coating is located either in the dielectric film subjacent to the metallic functional layer or in the dielectric film superjacent to the metallic functional layer, in such a way that:

- either the absorbent material of all the absorbent layers (123, 165) is predominantly in the dielectric film (120) subjacent to the metallic functional layer (140), and the thin-film multilayer coating (14) is positioned on the inner face (11) of the substrate (10) in contact on another face (9) with the external space (ES);
- or the absorbent material of all the absorbent layers (123, 165) is predominantly in the dielectric film (160) superjacent to the metallic functional layer (140), and the thin-film multilayer coating (26) is positioned on the inner face (29) of the substrate (30) in contact on another face (31) with the internal space (IS).

3. The multiple glazing (100) as claimed in claim 1 or claim 2, *characterized in that* at least one substrate (10, 20, 30) has, on at least one face (11, 19, 21, 29) in contact with a gas-filled cavity (15, 25), an antireflection film (18, 22) which, relative to said gas-filled cavity (15, 25), is opposite a thin-film multilayer coating (14, 26) having reflection properties in the infrared and/or in solar radiation.

4. The multiple glazing (100) as claimed in any one of claims 1 to 3, *characterized in that* the total thickness e of the absorbent layer (123, 165) in nanometers of the thin-film multilayer coating (14) positioned on the inner face (11) of the substrate (10) is such that: $e = ae_{140} + 55 - SF$ where:

$$0.5 \text{ nm} < e < 10 \text{ nm};$$

$$-1.5 < a < 0;$$

$e_{140}$ is physical thickness of the metallic functional layer (140): 5 nm $\leq e_{140} \leq$ 20 nm; and
SF is the solar factor of the multiple glazing in %.

5. The multiple glazing (100) as claimed in any one of claims 1 to 4, *characterized in that* at least one absorbent layer (123, 165), and preferably all the absorbent layers, is or are based on a nitride and in particular based on niobium nitride NbN or based on titanium nitride TiN.

6. The multiple glazing (100) as claimed in any one of claims 1 to 5, *characterized in that* said (or each) absorbent layer (123, 165) has a thickness between 0.5 and 10 nm, including these values, or even between 2 and 8 nm, including these values.

7. The multiple glazing (100) as claimed in any one of claims 1 to 6, *characterized in that* said subjacent dielectric films (120) and superjacent dielectric films (160) each comprise at least one dielectric layer (122, 166) based on silicon nitride optionally doped with at least one other element, such as aluminum.

8. The multiple glazing (100) as claimed in any one of claims 1 to 7, *characterized in that* each absorbent layer (123, 165) is placed in the dielectric film between two dielectric layers (122, 124; 164, 166) which are both based on silicon nitride, optionally doped with at least one other element, such as aluminum.

9. The multiple glazing (100) as claimed in any one of claims 1 to 8, *characterized in that* the functional layer (140) is placed directly on an underblocker film (130) placed between the functional layer (140) and the dielectric film (120) subjacent to the functional layer, and/or the functional layer (140) is deposited directly beneath an overblocker film (150) placed between the functional layer (140) and the dielectric film (160) superjacent to the functional layer *and in that* the underblocker film (130) and/or the overblocker film (150) comprise/comprises a thin layer based on nickel or titanium having a physical thickness e' such that 0.2 nm $\leq$ e' $\leq$ 2.5 nm.

10. The multiple glazing (100) as claimed in any one of claims 1 to 9, *characterized in that* the final layer or overcoat (168) of the superjacent dielectric film (160), that furthest away from the substrate, is based on an oxide, preferably deposited substoichiometrically, and especially is based on titanium ($TiO_x$) or based on a mixed tin zinc oxide ($SnZnO_x$).

11. The use of a thin-film multilayer coating (14, 26) having reflection properties in the infrared and/or in solar radiation, comprising a single metallic functional layer (140), in particular based on silver or on a metal alloy containing silver, and two dielectric films (120, 160), said films each comprising at least one dielectric layer (122, 126; 164, 168), said functional layer (140) being placed between the two dielectric films (120, 160) and said thin-film multilayer coating (14, 26) being placed on an inner face (11, 29) of at least one substrate (10, 30) for producing multiple glazing (100) as claimed in any one of claims 1 to 10, comprising at least two substrates (10, 30) which are held together by a frame structure (90), in which glazing a gas-filled cavity (15) lies between two substrates.

12. A process for manufacturing multiple glazing (100) as claimed in any one of claims 1 to 10, comprising at least two substrates (10, 30) that are held together by a frame structure (90), said glazing providing a separation between an external space (ES) and an internal space (IS), in which at least one gas-filled cavity (15) lies between the two substrates, one substrate (10, 30) being coated on an inner face (11, 29) in contact with the gas-filled cavity (15) with a thin-film multilayer coating (14, 26) having reflection properties in the infrared and/or in solar radiation, said coating comprising a single metallic functional layer (140), in particular based on silver or a metal alloy containing silver, and two dielectric films (120, 160), said films each comprising at least one dielectric layer (122, 126; 164, 168), said functional layer (140) being placed between the two dielectric films (120, 160), *characterized in that* both dielectric films (120, 160) include an absorbent layer (123, 165) which is placed in the dielectric film between two dielectric layers (122, 126; 162, 166), the absorbent material of the absorbent layers (123, 165) being predominantly in the dielectric film (120) subjacent to the metallic functional layer (140) or predominantly in the dielectric film (160) superjacent to the metallic functional layer (140) with more than half of the total thickness of the absorbent material of the absorbent layers of the multilayer coating is located either in the dielectric film subjacent to the metallic functional layer or in the dielectric film superjacent to the metallic functional layer, in such a way that:

   - either the substrate (10) is positioned in the frame structure (90) in roder for its inner face (11) to include a thin-film multilayer coating (14), the absorbent material of all the absorbent layers (123, 165) of which is predominantly in the dielectric film (120) subjacent to the metallic functional layer (140) and for its other face (9) to be in contact with the external space (ES);

- or the substrate (30) is positioned in the flame structure (90) in order for its inner face (29) to include a thin-film multilayer coating (26), the absorbent material of all the absorbent layers (123, 165) of which is predominantly in the dielectric film (160) subjacent to the metallic functional layer (140) and for its other face (31) to be in contact with the internal space (IS).

168
166
162
150
130
128
126
122

160
140
120

10/30

Fig. 1

168
166
165
164
162
150
130
128
126
124
123
122

160
140
120

10/30

Fig. 4

100

90

ES

15

30

IS

9

11

29

31

14

10/10'

Fig. 2

100

90

30/30'

ES

10

15

IS

11

29

31

9

26

Fig. 3

Fig. 5

Fig. 6

**EP 2 379 463 B1**

## RÉFÉRENCES CITÉES DANS LA DESCRIPTION

**Documents brevets cités dans la description**

- WO 0248065 A

- WO 2007101964 A